# EUROPEAN PATENT SPECIFICATION

(11) **EP 4 520 984 B1**
(45) Date of publication and mention of the grant of the patent: **28.01.2026**
(21) Application number: 24772910.6
(22) Date of filing: 29.02.2024
(51) Int. Cl.: F16C 11/04, H04M 1/02, G06F 1/16, G09F 9/30

(54) **ROTATING SHAFT MECHANISM AND ELECTRONIC DEVICE**
SCHARNIERMECHANISMUS UND ELEKTRONISCHE VORRICHTUNG
MÉCANISME D'ARBRE ROTATIF ET DISPOSITIF ÉLECTRONIQUE

(30) Priority: 20.07.2023 CN 202310898042
(43) Date of publication of application: 12.03.2025
(73) Proprietor: Huawei Technologies Co., Ltd., Shenzhen, Guangdong 518129 (CN)
(72) Inventor: SHI, Tuo, Shenzhen, Guangdong 518129 (CN); ZHAN, Qiang, Shenzhen, Guangdong 518129 (CN)
(74) Representative: Goddar, Heinz J.
(86) International application number: PCT/CN2024/079422
(87) International publication number: WO 2025/015935

(56) References cited:
- WO-A1-2022/242619
- WO-A1-2023/070289
- CN-A- 114 185 398
- CN-A- 115 766 918
- CN-U- 216 951 253
- CN-U- 218 760 886
- CN-U- 218 888 549
- US-A1- 2022 303 371
- US-A1- 2024 094 785

## Description

### CROSS-REFERENCE TO RELATED APPLICATIONS

This application claims priority to Chinese Patent Application No. 202310898042.0, filed with the China National Intellectual Property Administration on July 20, 2023 and entitled "HINGE MECHANISM AND ELECTRONIC DEVICE".

### TECHNICAL FIELD

This application relates to the field of electronic device technologies, and in particular, to a hinge mechanism and an electronic device.

### BACKGROUND

An included angle of a foldable electronic device in a flattened state is very important for fineness of the device. Usually, an included angle of an existing foldable electronic device in a flattened state is controlled based on a thickness size of a stop plane between rotational fitting parts, for example, a thickness size of a stop plane between an arc arm of a hinge and a main shaft. However, a size and a fitting tolerance of the rotational fitting part are large, and reliability of control of the included angle in the flattened state is low. Therefore, the foldable electronic device is likely to be over-folded, and a flexible display of the foldable electronic device is likely to be damaged.

### SUMMARY

This application provides a hinge mechanism and an electronic device, to resolve a problem of low reliability of control of an included angle of a foldable electronic device in a flattened state.
The invention is defined by the appended independent claim. Additional embodiments are defined by the dependent claims.

According to a first aspect, this application provides a hinge mechanism. The hinge mechanism may be used in a foldable electronic device, where the hinge mechanism is disposed opposite to a foldable part of a flexible display of the electronic device, and the electronic device is unfolded or folded by using the hinge mechanism. The hinge mechanism may include a main shaft, a first housing support, a second housing support, and a flatness stop mechanism, where the first housing support and the second housing support may be respectively disposed on two opposite sides of the main shaft, and the flatness stop mechanism may include a first stop structure and a second stop structure. The first stop structure may include a first connecting rod and a first stop block, the first connecting rod may be rotatably connected to the main shaft, the first connecting rod may be slidably connected to the first housing support, the first stop block may be fastened to the first housing support, and the first stop block is disposed opposite to the first connecting rod. The second stop structure may include a second connecting rod and a second stop block, where the second connecting rod may be rotatably connected to the main shaft, the second connecting rod may be slidably connected to the second housing support, the second stop block may be fastened to the second housing support, and the second stop block is disposed opposite to the second connecting rod. The first connecting rod may be in transmission connection to the second connecting rod. When the electronic device is unfolded or folded, the first housing support and the second housing support may rotate synchronously away from or close to each other relative to the main shaft, and the first connecting rod and the second connecting rod may rotate synchronously away from or close to each other relative to the main shaft. The first connecting rod may slide relative to the first housing support, and the second connecting rod may slide relative to the second housing support. In a process in which the electronic device is unfolded to a flattened state, the first connecting rod may slide in a direction away from the first housing support, and the second connecting rod may slide in a direction away from the second housing support. When the electronic device is unfolded to the flattened state, the first connecting rod may press against the first stop block, and the second connecting rod may press against the second stop block. In this way, the first connecting rod and the second connecting rod are prevented from respectively sliding in directions away from the first housing support and the second housing support.

In the technical solution provided in this application, in a process in which the electronic device is unfolded to the flattened state, the first connecting rod slides in a direction away from the first housing support, and when the electronic device is unfolded to the flattened state, the first connecting rod presses against the first stop block, so that the first connecting rod is restricted from continuously sliding relative to the first housing support, and the first housing support is restricted from continuously rotating in an unfolding direction relative to the main shaft. Similarly, the second connecting rod slides in a direction away from the second housing support, and when the electronic device is unfolded to the flattened state, the second connecting rod presses against the second stop block, so that the second connecting rod is restricted from continuously sliding relative to the second housing support, and the second housing support is further restricted from continuously rotating in the unfolding direction relative to the main shaft. Rotation of both the first housing support and the second housing support in the unfolding direction is restricted in the flattened state, so that an included angle of the electronic device in the flattened state can be reliably controlled, the electronic device is not likely to be over-folded, and the flexible display of the electronic device is not likely to be damaged.

In a specific implementable solution, a first sliding slot may be disposed on the first housing support, the first sliding slot may extend in a direction away from the main shaft, and the first connecting rod may be slidably disposed in the first sliding slot. When the electronic device is unfolded or folded, the first connecting rod may slide relative to the first housing support in the direction away from the first housing support or a direction close to the first housing support. In this way, the first connecting rod is slidably connected to the first housing support. A second sliding slot may be disposed on the second housing support, the second sliding slot may extend in a direction away from the main shaft, and the second connecting rod may be slidably disposed in the second sliding slot. When the electronic device is unfolded or folded, the second connecting rod may slide relative to the second housing support in the direction away from the second housing support or a direction close to the second housing support. In this way, the second connecting rod is slidably connected to the second housing support.

When the sliding slot is specifically disposed, a first avoidance slot may be disposed in the first sliding slot, and the first avoidance slot may be disposed on a side wall that is of the first sliding slot and that is a direction perpendicular to a rotation axial direction of the hinge mechanism. The first avoidance slot may provide avoidance space for rotation that is of the first connecting rod relative to the first housing support and that may exist in a process in which the first connecting rod slides relative to the first housing support, to avoid interference to sliding of the first connecting rod. A second avoidance slot may be disposed in the second sliding slot, and the second avoidance slot may be disposed on a side wall that is of the second sliding slot and that is in the direction perpendicular to the rotation axial direction of the hinge mechanism. The second avoidance slot may provide avoidance space for rotation that is of the second connecting rod relative to the second housing support and that may exist in a process in which the second connecting rod slides relative to the second housing support, to avoid interference to sliding of the second connecting rod.

In a specific implementable solution, a first opening may be disposed in the first sliding slot in the direction perpendicular to the rotation axial direction of the hinge mechanism, the first stop block may cover the first opening, and a part of the first connecting rod may be located between the first stop block and the first housing support. The first stop block and the first housing support clamp a part of the first connecting rod, so that the first connecting rod can be stably maintained in the first sliding slot, and the first connecting rod can be prevented from shaking in the direction perpendicular to the rotation axial direction of the hinge mechanism. Therefore, sliding stability and smoothness of the first connecting rod are improved. A second opening may be disposed in the second sliding slot in the direction perpendicular to the rotation axial direction of the hinge mechanism, the second stop block may cover the second opening, and a part of the second connecting rod may be located between the second stop block and the second housing support. The second stop block and the second housing support clamp a part of the second connecting rod, so that the second connecting rod can be stably maintained in the second sliding slot, and the second connecting rod can be prevented from shaking in the direction perpendicular to the rotation axial direction of the hinge mechanism. Therefore, sliding stability and smoothness of the second connecting rod are improved.

In a specific implementable solution, a first concave part and a second concave part may be disposed in the first sliding slot, the first concave part and the second concave part may be respectively disposed on two side walls that are of the first sliding slot and that are opposite to each other in the rotation axial direction of the hinge mechanism, and the first connecting rod may be slidably connected to the first concave part and the second concave part. The first concave part and the second concave part may provide a sliding rail for sliding of the first connecting rod in the first sliding slot, so that sliding stability of the first connecting rod can be improved. A third concave part and a fourth concave part may be disposed in the second sliding slot, the third concave part and the fourth concave part may be respectively disposed on two side walls that are of the second sliding slot and that are opposite to each other in the rotation axial direction of the hinge mechanism, and the second connecting rod may be slidably connected to the third concave part and the fourth concave part. The third concave part and the fourth concave part may provide a sliding rail for sliding of the second connecting rod in the second sliding slot, so that sliding stability of the second connecting rod can be improved.

When the connecting rod is specifically disposed, a first sliding part and a second sliding part may be respectively disposed on two sides of the first connecting rod in the rotation axial direction of the hinge mechanism, and the first sliding part and the second sliding part may be separately slidably connected to the side wall that is of the first sliding slot and that is in the direction perpendicular to the rotation axial direction of the hinge mechanism. When the first connecting rod slides, the first sliding part and the second sliding part are used as parts of the first connecting rod in contact with the first sliding slot and the first stop block, and the first sliding part and the second sliding part are respectively disposed on the two sides of the first connecting rod in the rotation axial direction of the hinge mechanism, so that overall sliding stability of the first connecting rod can be improved. A thickness of a part of the first connecting rod except the first sliding part and the second sliding part may be appropriately thin, so that an overall weight of the first connecting rod can be reduced, and rotation of the first connecting rod relative to the first housing support may be further allowed to be implemented in a process in which the first connecting rod slides relative to the first housing support. A third sliding part and a fourth sliding part may be respectively disposed on two sides of the second connecting rod in the rotation axial direction of the hinge mechanism, and the third sliding part and the fourth sliding part may be separately slidably connected to the side wall that is of the second sliding slot and that is in the direction perpendicular to the rotation axial direction of the hinge mechanism. When the second connecting rod slides, the third sliding part and the fourth sliding part are used as parts of the second connecting rod in contact with the second sliding slot and the second stop block, and the third sliding part and the fourth sliding part are respectively disposed on the two sides of the second connecting rod in the rotation axial direction of the hinge mechanism, so that stability of overall sliding of the second connecting rod can be improved. A thickness of a part of the second connecting rod except the third sliding part and the fourth sliding part may be appropriately thin, so that an overall weight of the second connecting rod can be reduced, and rotation of the second connecting rod relative to the second housing support may be further allowed to be implemented in a process in which the second connecting rod slides relative to the second housing support.

In a specific implementable solution, a first arc-shaped surface may be provided on an end that is of the first sliding part and that is away from the main shaft, and a second arc-shaped surface may be provided on an end that is of the second sliding part and that is away from the main shaft. When the first connecting rod slides, the first arc-shaped surface is in contact with the first sliding slot and the first stop block, and the second arc-shaped surface is also in contact with the first sliding slot and the first stop block, so that sliding precision and smoothness of the first connecting rod can be ensured. A third arc-shaped surface may be provided on an end that is of the third sliding part and that is away from the main shaft, and a fourth arc-shaped surface may be provided on an end that is of the fourth sliding part and that is away from the main shaft. When the second connecting rod slides, the third arc-shaped surface is in contact with the second sliding slot and the second stop block, and the fourth arc-shaped surface is also in contact with the second sliding slot and the second stop block, so that sliding precision and smoothness of the second connecting rod can be ensured.

In a specific implementable solution, a cross-sectional area of the first sliding part in the rotation axial direction of the hinge mechanism decreases from the end away from the main shaft to an end close to the main shaft, and a cross-sectional area of the second sliding part in the rotation axial direction of the hinge mechanism decreases from the end away from the main shaft to an end close to the main shaft. The first sliding part and the second sliding part are wedge-shaped structures, so that not only sliding precision and smoothness of the first connecting rod can be ensured, but also wear resistance of the sliding part can be improved. Therefore, sliding stability of the first connecting rod and a service life of the first connecting rod can be improved. A cross-sectional area of the third sliding part in the rotation axial direction of the hinge mechanism decreases from the end away from the main shaft to an end close to the main shaft, and a cross-sectional area of the fourth sliding part in the rotation axial direction of the hinge mechanism decreases from the end away from the main shaft to an end close to the main shaft. The third sliding part and the fourth sliding part are wedge-shaped structures, so that not only sliding precision and smoothness of the second connecting rod can be ensured, but also wear resistance of the sliding part can be improved. Therefore, sliding stability of the second connecting rod and a service life of the second connecting rod can be improved.

In a specific implementable solution, a first stop slot may be disposed on the first connecting rod in a sliding direction of the first connecting rod, a first stop protrusion may be disposed on a surface that is of the first stop block and that faces the first connecting rod, and the first stop protrusion may extend into the first stop slot. When the electronic device is unfolded to the flattened state, that the first connecting rod presses against the first stop block includes: an end that is of the first stop slot and that is away from the main shaft may press against the first stop protrusion. In this way, the first connecting rod can be restricted from continuously sliding away from the first housing support. In other words, the first housing support and the first connecting rod are restricted from continuously sliding relative to each other in the unfolding direction, so that the first housing support is restricted from continuously rotating relative to the main shaft in the unfolding direction. A second stop slot may be disposed on the second connecting rod in a sliding direction of the second connecting rod, a second stop protrusion may be disposed on a surface that is of the second stop block and that faces the second connecting rod, and the second stop protrusion may extend into the second stop slot. When the electronic device is unfolded to the flattened state, that the second connecting rod presses against the second stop block includes: an end that is of the second stop slot and that is away from the main shaft may press against the second stop protrusion. In this way, the second connecting rod can be restricted from continuously sliding away from the second housing support. In other words, the second housing support and the second connecting rod are restricted from continuously sliding relative to each other in the unfolding direction, so that the second housing support is restricted from continuously rotating relative to the main shaft in the unfolding direction.

In a specific implementable solution, a first mounting slot and a second mounting slot may be disposed on the first housing support, the first mounting slot and the second mounting slot may be respectively located on the two sides of the first connecting rod in the rotation axial direction of the hinge mechanism, and two ends of the first stop block in the rotation axial direction of the hinge mechanism may be respectively fastened to the first mounting slot and the second mounting slot. In this way, the first stop block can be fastened to the first housing support. A third mounting slot and a fourth mounting slot may be disposed on the second housing support, the third mounting slot and the fourth mounting slot may be respectively located on the two sides of the second connecting rod in the rotation axial direction of the hinge mechanism, and two ends of the second stop block in the rotation axial direction of the hinge mechanism may be respectively fastened to the third mounting slot and the fourth mounting slot. In this way, the second stop block can be fastened to the second housing support.

In a specific implementable solution, a first gear part may be disposed at an end that is of the first connecting rod and that is rotatably connected to the main shaft, a second gear part may be disposed at an end that is of the second connecting rod and that is rotatably connected to the main shaft, and the first gear part may be in transmission connection to the second gear part, so that the first connecting rod and the second connecting rod may synchronously rotate away from or close to each other relative to the main shaft. In this way, the first connecting rod and the second connecting rod can rotate synchronously relative to the main shaft.

In a specific implementable solution, a synchronization gear group may be disposed on the main shaft, the synchronization gear group may be located between the first connecting rod and the second connecting rod, and the first gear part may be in transmission connection to the second gear part through the synchronization gear group. The synchronization gear group may include an even number of transmission gears that are sequentially in transmission connection to each other. In this way, the first gear part and the second gear part can rotate synchronously, so that the first connecting rod and the second connecting rod rotate synchronously.

According to a second aspect, this application further provides an electronic device, including a first housing, a second housing, a flexible display, and the hinge mechanism according to any one of the implementable solutions of the first aspect. The first housing and the second housing may be respectively disposed on two opposite sides of the hinge mechanism, the first housing may be fastened to the first housing support, and the second housing may be fastened to the second housing support. The flexible display may continuously cover the first housing, the second housing, and the hinge mechanism, and the flexible display may be fastened to the first housing and the second housing.

According to the electronic device provided in this application, the included angle in the flattened state is reliably controlled, the electronic device is not likely to be over-folded, and the flexible display of the electronic device is not likely to be damaged.

### BRIEF DESCRIPTION OF DRAWINGS

FIG. 1 is a diagram of an exploded structure of a hinge mechanism according to an embodiment of this application;
FIG. 2 is a diagram of an assembly structure of a hinge mechanism according to an embodiment of this application;
FIG. 3 is a diagram of a structure of a hinge mechanism in a folded state according to an embodiment of this application;
FIG. 4 is a diagram of a structure of a hinge mechanism in a flattened state according to an embodiment of this application;
FIG. 5 is a diagram of an assembly structure of a partial structure of a hinge mechanism according to an embodiment of this application;
FIG. 6 is a diagram of a structure of a first housing support of a hinge mechanism according to an embodiment of this application;
FIG. 7 is a diagram of a structure of a first stop block of a hinge mechanism according to an embodiment of this application;
FIG. 8 is a diagram of a structure of a hinge mechanism according to another embodiment of this application;
FIG. 9 is a diagram of a partial structure of a hinge mechanism according to another embodiment of this application; and
FIG. 10 is a diagram of a structure of a first connecting rod of a hinge mechanism according to an embodiment of this application.

### Reference numerals:

1: main shaft; 2: first housing support; 3: second housing support; 10: first stop structure; 20: second stop structure;
21: first sliding slot; 211: first avoidance slot; 212: first concave part; 213: second concave part; 22: first mounting slot;
23: second mounting slot; 31: second sliding slot; 312: third concave part; 313: fourth concave part; 101: first connecting rod;
102: first stop block; 1011: first sliding part; 1012: second sliding part; 1013: first stop slot;
1014: first mounting hole; 1015: first gear part; 10111: first arc-shaped surface; 10121: second arc-shaped surface;
1021: third sliding slot; 1022: first stop protrusion; 1023: first adjustment slot; 201: second connecting rod;
202: second stop block; and 2015: second gear part.

### DESCRIPTION OF EMBODIMENTS

To make the objectives, technical solutions, and advantages of this application clearer, the following further describes the embodiments of this application in detail with reference to the accompanying drawings. Identical reference numerals in the accompanying drawings denote identical or similar structures. Therefore, repeated description thereof is omitted. Expressions of locations and directions in embodiments of this application are described by using the accompanying drawings as an example. The accompanying drawings in embodiments of this application are merely used to illustrate relative position relationships and do not represent an actual scale.

Specific details are described in the following description to facilitate understanding of this application. However, embodiments of this application can be implemented in a plurality of manners different from those described herein, and a person skilled in the art may make similar promotion without departing from the connotation of the embodiments of this application. Therefore, this application is not limited to the following disclosed specific implementations.

For ease of understanding, an application scenario of a hinge mechanism in embodiments of this application is first described. The hinge mechanism provided in embodiments of this application may be used in an electronic device, for example, a mobile terminal like a mobile phone, a tablet computer, or a notebook computer. In a possible application scenario, the hinge mechanism provided in embodiments of this application may be used in a foldable electronic device, and is used as a component of a hinge module of the foldable electronic device.

The foldable electronic device usually includes a mechanical part, for example, a flexible display, a hinge module, and a housing. The housing includes a first housing and a second housing that are movably connected through the hinge module. When the entire foldable electronic device is unfolded or folded, the first housing rotates relative to the second housing, the hinge module provides a damping force, and the flexible display is bent.

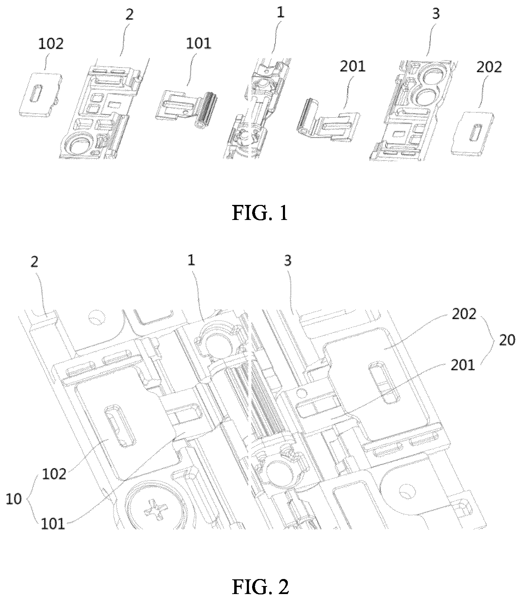

First, FIG. 1 is a diagram of an exploded structure of the hinge mechanism according to an embodiment of this application, and FIG. 2 is a diagram of an assembly structure of the hinge mechanism according to an embodiment of this application. As shown in FIG. 1 and FIG. 2, the hinge mechanism provided in embodiments of this application may include a main shaft 1, a first housing support 2, a second housing support 3, and a flatness stop mechanism. The first housing support 2 and the second housing support 3 may be respectively disposed on two opposite sides of the main shaft 1. The flatness stop mechanism includes two stop structures. The two stop structures are a first stop structure 10 and a second stop structure 20. The first stop structure 10 and the second stop structure 20 may be respectively disposed on two opposite sides of the main shaft 1.

In embodiments of this application, the first stop structure 10 may include a first connecting rod 101 and a first stop block 102. The first connecting rod 101 may be rotatably connected to the main shaft 1, and a rotation axial direction of the first connecting rod 101 may be parallel to a rotation axial direction of the hinge mechanism. The first connecting rod 101 may be simultaneously slidably connected to the first housing support 2. The first stop block 102 may be fastened to the first housing support 2. For example, the first stop block 102 may be welded to the first housing support 2. The first stop block 102 is disposed opposite to the first connecting rod 101. Specifically, the first stop block 102 is disposed at a location corresponding to the first connecting rod 101.

Similar to the first stop structure 10, the second stop structure 20 may include a second connecting rod 201 and a second stop block 202. The second connecting rod 201 is rotatably connected to the main shaft 1, the second connecting rod 201 is slidably connected to the second housing support 3, and the second stop block 202 is fastened to the second housing support 3. The second stop block 202 is disposed opposite to the second connecting rod 201.

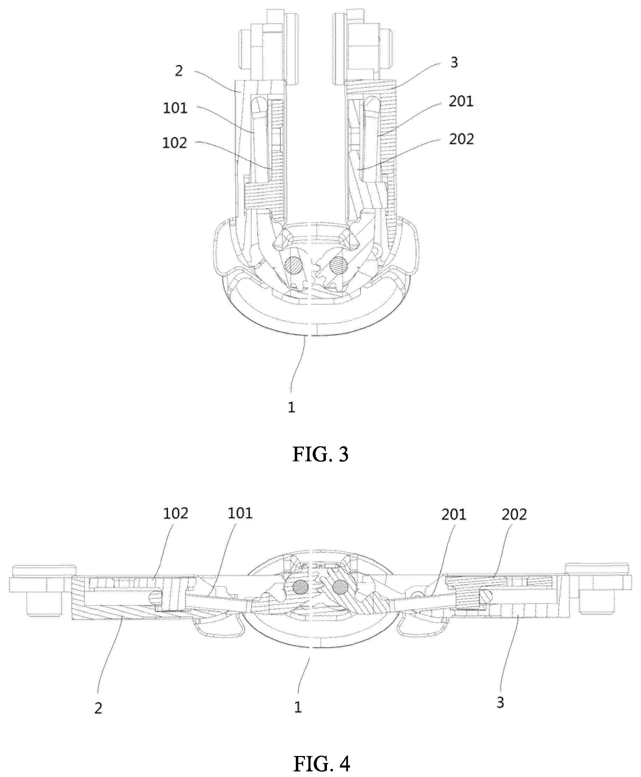

FIG. 3 is a diagram of a structure of the hinge mechanism in a folded state according to an embodiment of this application, and FIG. 4 is a diagram of a structure of the hinge mechanism in a flattened state according to an embodiment of this application. As shown in FIG. 3 and FIG. 4, in specific implementation, the first connecting rod 101 may be in transmission connection to the second connecting rod 201. When the electronic device is unfolded or folded, the first housing support 2 and the second housing support 3 may rotate synchronously away from or close to each other relative to the main shaft 1. The first connecting rod 101 and the second connecting rod 201 may be driven to rotate synchronously away from or close to each other relative to the main shaft 1, the first connecting rod 101 may slide relative to the first housing support 2, and the second connecting rod 201 may slide relative to the second housing support 3. In a process in which the electronic device is unfolded to the flattened state, the first connecting rod 101 slides in a direction away from the first housing support 2, and when the electronic device is unfolded to the flattened state, the first connecting rod 101 presses against the first stop block 102, so that the first connecting rod 101 is restricted from continuously sliding relative to the first housing support 2. In other words, the first connecting rod 101 is prevented from continuously sliding in the direction away from the first housing support 2, so that the first housing support 2 is restricted from continuously rotating in an unfolding direction relative to the main shaft 1. Similarly, the second connecting rod 201 slides in a direction away from the second housing support 3, and when the electronic device is unfolded to the flattened state, the second connecting rod 201 presses against the second stop block 202, so that the second connecting rod 201 is restricted from continuously sliding relative to the second housing support 3. In other words, the second connecting rod 201 is prevented from continuously sliding in the direction away from the second housing support 3, so that the second housing support 3 is restricted from continuously rotating in the unfolding direction relative to the main shaft 1. Rotation of both the first housing support 2 and the second housing support 3 in the unfolding direction is restricted in the flattened state, so that an included angle of the electronic device in the flattened state can be reliably controlled, the electronic device is not likely to be over-folded, and the flexible display of the electronic device is not likely to be damaged. In addition, in an assembly process, a relative location of the first stop block 102 on the first housing support 2 and a relative location of the second stop block 202 on the second housing support 3 may be adjusted, so that an included angle between the first housing support 2 and the second housing support 3 in the flattened state may be adjusted. In other words, the included angle of the electronic device in the flattened state is adjusted, so that fitting tolerance between covered components is easily adjusted, and an ideal included angle in the flattened state is easily achieved.

For ease of description, in the following embodiments of this application, a specific disposing manner of the first stop structure 10 is mainly used as an example to describe the hinge mechanism, and the second stop structure 20 may be disposed with reference to the first stop structure 10. It may be understood that a design of the second stop structure 20 may be completely the same as that of the first stop structure 10, or for a design of the second stop structure 20, reference may be made only to components and connection relationships included in the first stop structure 10, other parameters may be adaptively adjusted, and the design of the second stop structure 20 does not need to be completely the same as that of the first stop structure 10.

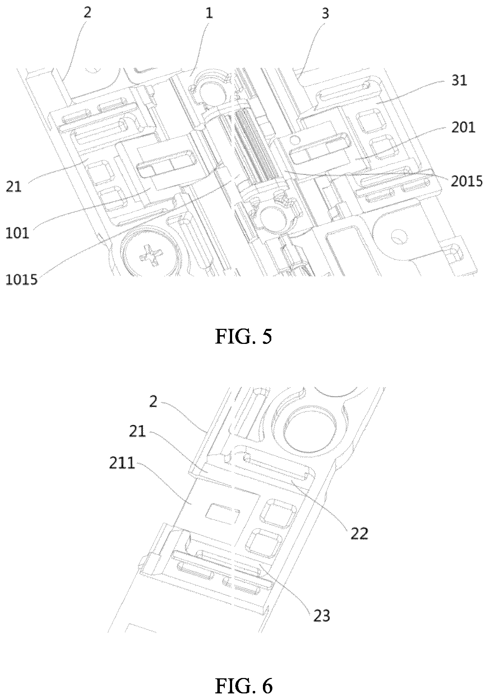

FIG. 5 is a diagram of an assembly structure of a partial structure of the hinge mechanism according to an embodiment of this application, and FIG. 6 is a diagram of a structure of the first housing support of the hinge mechanism according to an embodiment of this application. Different from that in FIG. 2, the first stop block 102 and the second stop block 202 in FIG. 2 are not shown in FIG. 5. As shown in FIG. 5, in embodiments of this application, a first sliding slot 21 is disposed on the first housing support 2, and the first sliding slot 21 extends in a direction away from the main shaft 1. For example, the hinge mechanism is used in an electronic device that is folded inward. Specifically, the first sliding slot 21 may be located on a surface that is of the first housing support 2 and that faces the flexible display. When the first housing support 2 is molded by using a mold, the first sliding slot 21 may be molded together by using the mold. The first connecting rod 101 may be slidably disposed in the first sliding slot 21, so that the first connecting rod 101 is slidably connected to the first housing support 2. When the electronic device is unfolded or folded, the first housing support 2 rotates relative to the main shaft 1 in the direction away from the main shaft 1 or a direction close to the main shaft 1, and drives the first connecting rod 101 to rotate relative to the main shaft 1 in the direction away from the main shaft 1 or the direction close to the main shaft 1. Simultaneously, the first connecting rod 101 slides relative to the first housing support 2 in a direction away from the first housing support 2 or a direction close to the first housing support 2.

As shown in FIG. 6, a first avoidance slot 211 may be disposed in the first sliding slot 21, and the first avoidance slot 211 may be disposed on a side wall that is of the first sliding slot 21 and that is in a direction perpendicular to a rotation axial direction of the hinge mechanism. As shown in FIG. 5, the first avoidance slot 211 may provide avoidance space for rotation that is of the first connecting rod 101 relative to the first housing support 2 and that may exist in a process in which the first connecting rod 101 slides relative to the first housing support 2, to avoid interference to sliding of the first connecting rod 101.

As shown in FIG. 2 and FIG. 6, a first opening may be disposed in the first sliding slot 21 in the direction perpendicular to the rotation axial direction of the hinge mechanism. For example, when the hinge mechanism is used in an electronic device that is folded inward, the first opening may face the flexible display. The first stop block 102 may cover the first opening. A part of the first connecting rod 101 may be located between the first stop block 102 and the first housing support 2. In other words, a part of the first connecting rod 101 may be located in accommodation space formed by the first stop block 102 and the first sliding slot 21, and the first stop block 102 and the first housing support 2 clamp a part of the first connecting rod 101. The first stop block 102 may enable the first connecting rod 101 to be stably maintained in the first sliding slot 21, so that the first connecting rod 101 is prevented from shaking in the direction perpendicular to the rotation axial direction of the hinge mechanism, and sliding stability and smoothness of the first connecting rod 101 is improved. In this specific implementation, when the electronic device is unfolded to the flattened state, the first stop block 102 has a function of restricting the first connecting rod 101 to continue sliding relative to the first housing support 2. In addition, the first stop block 102 further has a function of clamping a part of the first connecting rod 101 together with the first housing support 2, to prevent the first connecting rod 101 from shaking in the direction perpendicular to the rotation axial direction of the hinge mechanism.

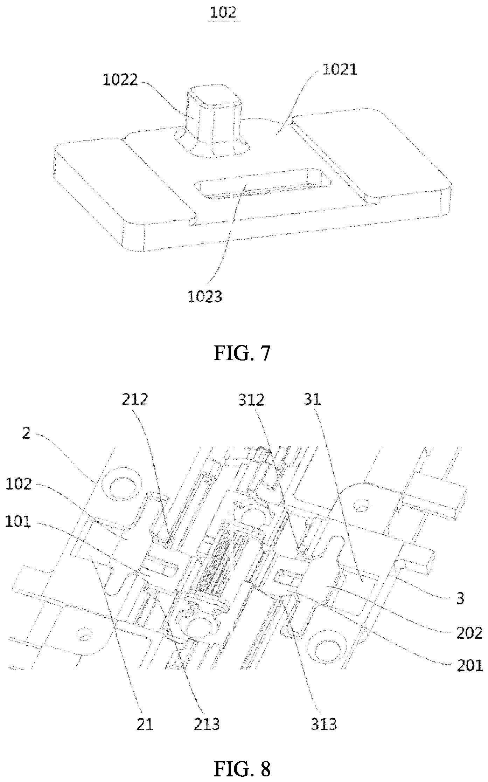

FIG. 7 is a diagram of a structure of the first stop block of the hinge mechanism according to an embodiment of this application. As shown in FIG. 5 and FIG. 7, a third sliding slot 1021 may be disposed on a surface that is of the first stop block 102 and that faces the first connecting rod 101. The third sliding slot 1021 and the first sliding slot 21 may be aligned in the direction perpendicular to the rotation axial direction of the hinge mechanism, and the third sliding slot 1021 and the first sliding slot 21 jointly form accommodation space, to accommodate a part of the first connecting rod 101. The third sliding slot 1021 may share a part of a depth of the accommodation space in the direction perpendicular to the rotation axial direction of the hinge mechanism, so that a depth of the first sliding slot 21 may be shallow. This helps maintain structural strength of the first housing support 2.

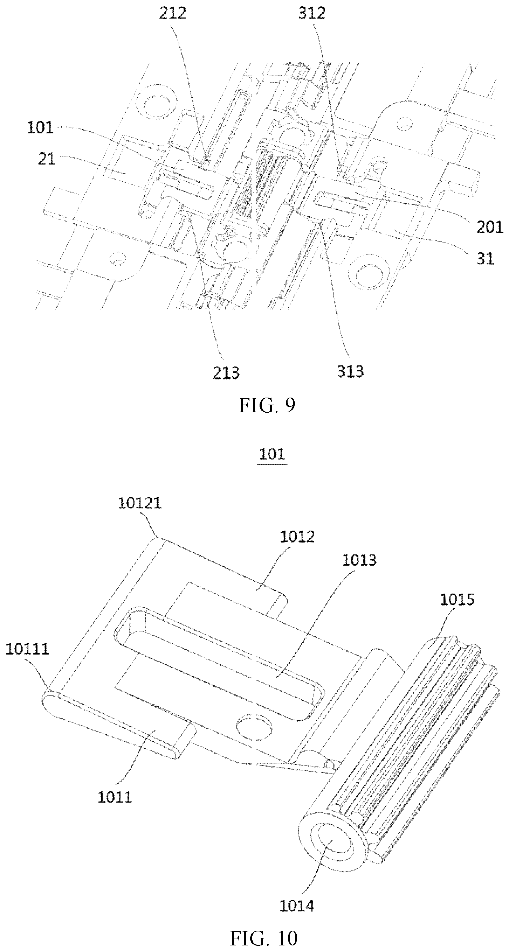

FIG. 8 is a diagram of a structure of a hinge mechanism according to another embodiment of this application, and FIG. 9 is a diagram of a partial structure of a hinge mechanism according to another embodiment of this application. Different from that in FIG. 5, a structure of a first sliding slot 21 in FIG. 8 is changed. Different from that in FIG. 8, the first stop block 102 and the second stop block 202 in FIG. 8 are not shown in FIG. 9. As shown in FIG. 8, a first concave part 212 and a second concave part 213 may be disposed in the first sliding slot 21. The first concave part 212 and the second concave part 213 are respectively disposed on two side walls that are of the first sliding slot 21 and that are opposite to each other in a rotation axial direction of a hinge mechanism. A first connecting rod 101 may be slidably connected to the first concave part 212 and the second concave part 213. The first concave part 212 and the second concave part 213 may provide a sliding rail for sliding of the first connecting rod 101 in the first sliding slot 21, so that sliding stability of the first connecting rod 101 can be improved. Specifically, the first concave part 212 and the second concave part 213 may be formed in the first sliding slot 21 in a slot digging manner. In this specific implementation, when an electronic device is unfolded to a flattened state, the first stop block 102 has a function of restricting the first connecting rod 101 to continue sliding relative to the first housing support 2. The first concave part 212 and the second concave part 213 have a function of restricting the first connecting rod 101 to shake in a direction perpendicular to a rotation axial direction of the hinge mechanism.

FIG. 10 is a diagram of a structure of the first connecting rod of the hinge mechanism according to an embodiment of this application. As shown in FIG. 5, FIG. 8, and FIG. 10, a first mounting hole 1014 may be disposed at an end that is of the first connecting rod 101 and that is rotatably connected to the main shaft 1. The first connecting rod 101 may be rotatably connected to the main shaft 1 through a connecting piece like a pin shaft that penetrates into the first mounting hole 1014. A first sliding part 1011 and a second sliding part 1012 may be respectively disposed on two sides of the first connecting rod 101 in the rotation axial direction of the hinge mechanism, and the first sliding part 1011 and the second sliding part 1012 may be separately slidably connected to a side wall that is of the first sliding slot 21 and that is in the direction perpendicular to the rotation axial direction of the hinge mechanism. When the first connecting rod 101 slides, the first sliding part 1011 and the second sliding part 1012 are used as parts of the first connecting rod 101 in contact with the first sliding slot 21 and the first stop block 102, and the first sliding part 1011 and the second sliding part 1012 are respectively disposed on the two sides of the first connecting rod 101 in the rotation axial direction of the hinge mechanism, so that overall sliding stability of the first connecting rod 101 can be improved. A thickness of a part of the first connecting rod 101 except the first sliding part 1011 and the second sliding part 1012 may be appropriately thin, so that an overall weight of the first connecting rod 101 can be reduced, and rotation of the first connecting rod 101 relative to the first housing support 2 may be further allowed to be implemented in a process in which the first connecting rod 101 slides relative to the first housing support 2. Specifically, when the first concave part 212 and the second concave part 213 are disposed in the first sliding slot 21, the first sliding part 1011 and the second sliding part 1012 may be respectively located in the first concave part 212 and the second concave part 213. The first sliding part 1011 may be slidably connected to a side wall that is of the first concave part 212 and that is in the direction perpendicular to the rotation axial direction of the hinge mechanism, and the second sliding part 1012 may be slidably connected to a side wall that is of the second concave part 213 and that is in the direction perpendicular to the rotation axial direction of the hinge mechanism, so that overall sliding stability of the first connecting rod 101 can be further improved.

In embodiments of this application, a first arc-shaped surface 10111 may be provided on an end that is of the first sliding part 1011 and that is away from the main shaft 1, and an axial direction of the first arc-shaped surface 10111 may be parallel to the rotation axial direction of the hinge mechanism. A second arc-shaped surface 10121 may be provided on an end that is of the second sliding part 1012 and that is away from the main shaft 1, and an axial direction of the second arc-shaped surface 10121 may also be parallel to the rotation axial direction of the hinge mechanism. When the first connecting rod 101 slides, the first arc-shaped surface 10111 is in contact with the first sliding slot 21 and the first stop block 102, and the second arc-shaped surface 10121 is also in contact with the first sliding slot 21 and the first stop block 102, so that sliding precision and smoothness of the first connecting rod 101 can be ensured. During specific implementation, the first arc-shaped surface 10111 and the second arc-shaped surface 10121 may extend in the rotation axial direction of the hinge mechanism to form a complete arc-shaped surface, so that molding is facilitated.

In some possible specific implementations, the first sliding part 1011 may be of a cylindrical structure, and the first arc-shaped surface 10111 is a part of a cylindrical surface of the first sliding part 1011. Similarly, the second sliding part 1012 may also be of a cylindrical structure, and the second arc-shaped surface 10121 is a part of a cylindrical surface of the second sliding part 1012. In some other possible specific implementations, a cross-sectional area of the first sliding part 1011 in the rotation axial direction of the hinge mechanism decreases from the end away from the main shaft 1 to an end close to the main shaft 1. This may be understood as that the first sliding part 1011 is of a wedge-shaped structure, and two ends of the wedge-shaped structure may separately have an arc-shaped surface. A cross-sectional area of the second sliding part 1012 in the rotation axial direction of the hinge mechanism decreases from the end away from the main shaft 1 to an end close to the main shaft 1. Similarly, this may be understood as that the second sliding part 1012 is of a wedge-shaped structure, and two ends of the wedge-shaped structure may also separately have an arc-shaped surface. The wedge-shaped sliding part can not only ensure sliding precision and smoothness of the first connecting rod 101, but also improve wear resistance of the sliding part. Therefore, sliding stability of the first connecting rod 101 and a service life of the first connecting rod 101 can be improved.

As shown in FIG. 7, a first stop slot 1013 may be disposed on the first connecting rod 101 in a sliding direction of the first connecting rod 101. A first stop protrusion 1022 may be disposed on a surface that is of the first stop block 102 and that faces the first connecting rod 101. During actual assembly, the first stop protrusion 1022 extends into the first stop slot 1013. When the electronic device is unfolded to the flattened state, the first connecting rod 101 presses against the first stop block 102. Specifically, an end that is of the first stop slot 1013 and that is away from the main shaft 1 presses against the first stop protrusion 1022, so that the first connecting rod 101 is restricted from continuously sliding away from the first housing support 2. In other words, the first housing support 2 and the first connecting rod 101 are restricted from continuously sliding relative to each other in an unfolding direction, so that the first housing support 2 is restricted from continuously rotating relative to the main shaft 1 in the unfolding direction. During specific implementation, the first stop slot 1013 may be a circumferentially closed slot, or may be a circumferentially unclosed half-open slot, as long as the first stop slot 1013 can perform the foregoing restricting functions.

As shown in FIG. 2 and FIG. 6, a first mounting slot 22 and a second mounting slot 23 may be disposed on the first housing support 2. For example, when the hinge mechanism is used in an electronic device that is folded inward, the first mounting slot 22 and the second mounting slot 23 may be located on a surface that is of the first housing support 2 and that faces the flexible display, and the first mounting slot 22 and the second mounting slot 23 may be respectively located on two sides of the first connecting rod 101 in the rotation axial direction of the hinge mechanism. Two ends of the first stop block 102 in the rotation axial direction of the hinge mechanism may be respectively fastened to the first mounting slot 22 and the second mounting slot 23, so that the first stop block 102 is fastened to the first housing support 2.

As shown in FIG. 7, during specific implementation, a first adjustment slot 1023 may be disposed on the first stop block 102, so that a relative location between the first stop block 102 and the first housing support 2 is adjusted in an assembly process, and a weight of the first stop block 102 can be appropriately reduced.

As described above, the second housing support 3 and the first housing support 2 may be respectively disposed on two opposite sides of the main shaft 1. During specific implementation, as shown in FIG. 5, a second sliding slot 31 is disposed on the second housing support 3. The second sliding slot 31 extends in a direction away from the main shaft 1. The second connecting rod 201 is slidably disposed in the second sliding slot 31. When the electronic device is unfolded or folded, the second connecting rod 201 slides relative to the second housing support 3 in a direction away from the second housing support 3 or a direction close to the second housing support 3.

In embodiments of this application, a second avoidance slot is disposed in the second sliding slot 31, and the second avoidance slot is disposed on a side wall that is of the second sliding slot 31 and that is in the direction perpendicular to the rotation axial direction of the hinge mechanism. As shown in FIG. 2, a second opening is disposed in the second sliding slot 31 in the direction perpendicular to the rotation axial direction of the hinge mechanism, the second stop block 202 covers the second opening, and a part of the second connecting rod 201 is located between the second stop block 202 and the second housing support 3.

In specific implementation, a fourth sliding slot is disposed on a surface that is of the second stop block 202 and that faces the second connecting rod 201, the fourth sliding slot and the second sliding slot 31 are aligned in the direction perpendicular to the rotation axial direction of the hinge mechanism, and the fourth sliding slot and the second sliding slot 31 jointly form accommodation space, to accommodate the second connecting rod 201.

In embodiments of this application, as shown in FIG.8, a third concave part 312 and a fourth concave part 313 are disposed in the second sliding slot 31. The third concave part 312 and the fourth concave part 313 are respectively disposed on two side walls that are of the second sliding slot 31 and that are opposite to each other in the rotation axial direction of the hinge mechanism, and the second connecting rod 201 is slidably connected to the third concave part 312 and the fourth concave part 313.

In embodiments of this application, a third sliding part and a fourth sliding part are respectively disposed on two sides of the second connecting rod 201 in the rotation axial direction of the hinge mechanism, and the third sliding part and the fourth sliding part may be separately slidably connected to a side wall that is of the second sliding slot 31 and that is in the direction perpendicular to the rotation axial direction of the hinge mechanism. A third arc-shaped surface is provided on an end that is of the third sliding part and that is away from the main shaft 1, and a fourth arc-shaped surface is provided on an end that is of the fourth sliding part and that is away from the main shaft 1. A cross-sectional area of the third sliding part in the rotation axial direction of the hinge mechanism decreases from the end away from the main shaft 1 to an end close to the main shaft 1. This may be understood as that the third sliding part is of a wedge-shaped structure. A cross-sectional area of the fourth sliding part in the rotation axial direction of the hinge mechanism decreases from the end away from the main shaft 1 to an end close to the main shaft 1. This may be understood as that the fourth sliding part is of a wedge-shaped structure.

In embodiments of this application, a second stop slot is disposed on the second connecting rod 201 in a sliding direction of the second connecting rod 201, a second stop protrusion is disposed on a surface that is of the second stop block 202 and that faces the second connecting rod 201, and the second stop protrusion extends into the second stop slot. When the electronic device is unfolded to the flattened state, an end that is of the second stop slot and that is away from the main shaft 1 may press against the second stop protrusion.

In embodiments of this application, a third mounting slot and a fourth mounting slot are disposed on the second housing support 3, the third mounting slot and the fourth mounting slot are respectively located on the two sides of the second connecting rod 201 in the rotation axial direction of the hinge mechanism, and two ends of the second stop block 202 in the rotation axial direction of the hinge mechanism are respectively fastened to the third mounting slot and the fourth mounting slot.

It may be understood that some features in the foregoing embodiments are described by using an example in which the hinge mechanism is used in an electronic device that is folded inward. In actual application, the hinge mechanism may alternatively be used in an electronic device that is folded outward. In this case, a setting location, an orientation, and the like of these features may be adaptively adjusted based on a change of a folding direction of the electronic device.

As shown in FIG. 5 and FIG. 10, a first gear part 1015 may be disposed at an end that is of the first connecting rod 101 and that is rotatably connected to the main shaft 1, and a second gear part 2015 may be disposed at an end that is of the second connecting rod 201 and that is rotatably connected to the main shaft 1. The first gear part 1015 is in transmission connection to the second gear part 2015, so that the first connecting rod 101 and the second connecting rod 201 rotate synchronously away from or close to each other relative to the main shaft 1. Specifically, the first gear part 1015 may include a plurality of first gear structures disposed around the rotation axial direction of the first connecting rod 101, and the second gear part 2015 may include a plurality of second gear structures disposed around a rotation axial direction of the second connecting rod 201. The first gear part 1015 meshes with the second gear part 2015 based on the plurality of first gear structures and the plurality of second gear structures, so that the first gear part 1015 rotates synchronously with the second gear part 2015.

In specific implementation, a synchronization gear group may be disposed on the main shaft 1, the synchronization gear group may be located between the first connecting rod 101 and the second connecting rod 201, and the first gear part 1015 may be in transmission connection to the second gear part 2015 through the synchronization gear group. The synchronization gear group may include an even number of transmission gears that are sequentially in transmission connection to each other. For example, the synchronization gear group includes two transmission gears that are sequentially in rotational connection to each other, so that the first gear part 1015 rotates synchronously with the second gear part 2015, and the first connecting rod 101 rotates synchronously with the second connecting rod 201. Specifically, an axial direction of the transmission gear may be parallel to the rotation axial direction of the hinge mechanism.

## Claims

1. A hinge mechanism, used in a foldable electronic device, wherein the hinge mechanism is disposed opposite to a foldable part of a flexible display of the electronic device, the electronic device is unfolded or folded by using the hinge mechanism, the hinge mechanism comprises a main shaft (1), a first housing support (2), a second housing support (3), and a flatness stop mechanism, the first housing support (2) and the second housing support (3) are respectively disposed on two opposite sides of the main shaft (1), and the flatness stop mechanism comprises a first stop structure (10) and a second stop structure (20), wherein
the first stop structure (10) comprises a first connecting rod (101) and a first stop block (102), wherein the first connecting rod (101) is rotatably connected to the main shaft (1), the first connecting rod (101) is slidably connected to the first housing support (2), the first stop block (102) is fastened to the first housing support (2), and the first stop block (102) is disposed opposite to the first connecting rod (101);
the second stop structure (20) comprises a second connecting rod (201) and a second stop block (202), wherein the second connecting rod (201) is rotatably connected to the main shaft (1), the second connecting rod (201) is slidably connected to the second housing support (3), the second stop block (202) is fastened to the second housing support (3), and the second stop block (202) is disposed opposite to the second connecting rod (201); and
the first connecting rod (101) is in transmission connection to the second connecting rod (201); when the electronic device is unfolded or folded, the first housing support (2) and the second housing support (3) rotate synchronously away from or close to each other relative to the main shaft (1), the first connecting rod (101) and the second connecting rod (201) rotate synchronously away from or close to each other relative to the main shaft (1), the first connecting rod (101) slides relative to the first housing support (2), and the second connecting rod (201) slides relative to the second housing support (3); in a process in which the electronic device is unfolded to a flattened state, the first connecting rod (101) slides in a direction away from the first housing support (2), and the second connecting rod (201) slides in a direction away from the second housing support (3); and when the electronic device is unfolded to the flattened state, the first connecting rod (101) presses against the first stop block (102), and the second connecting rod (201) presses against the second stop block (202).

2. The hinge mechanism according to claim 1, wherein
a first sliding slot (21) is disposed on the first housing support (2), the first sliding slot (21) extends in a direction away from the main shaft (1), the first connecting rod (101) is slidably disposed in the first sliding slot (21), and when the electronic device is unfolded or folded, the first connecting rod (101) slides relative to the first housing support (2) in the direction away from the first housing support (2) or a direction close to the first housing support (2); and
a second sliding slot (31) is disposed on the second housing support (3), the second sliding slot (31) extends in a direction away from the main shaft (1), the second connecting rod (201) is slidably disposed in the second sliding slot (31), and when the electronic device is unfolded or folded, the second connecting rod (201) slides relative to the second housing support (3) in the direction away from the second housing support (3) or a direction close to the second housing support (3).

3. The hinge mechanism according to claim 2, wherein
a first avoidance slot (211) is disposed in the first sliding slot (21), and the first avoidance slot (211) is disposed on a side wall that is of the first sliding slot (21) and that is in a direction perpendicular to a rotation axial direction of the hinge mechanism; and
a second avoidance slot is disposed in the second sliding slot (31), and the second avoidance slot is disposed on a side wall that is of the second sliding slot (31) and that is in the direction perpendicular to the rotation axial direction of the hinge mechanism.

4. The hinge mechanism according to claim 2 or 3, wherein
a first opening is disposed in the first sliding slot (21) in the direction perpendicular to the rotation axial direction of the hinge mechanism, the first stop block (102) covers the first opening, and a part of the first connecting rod (101) is located between the first stop block (102) and the first housing support (2); and
a second opening is disposed in the second sliding slot (31) in the direction perpendicular to the rotation axial direction of the hinge mechanism, the second stop block (202) covers the second opening, and a part of the second connecting rod (201) is located between the second stop block (202) and the second housing support (3).

5. The hinge mechanism according to any one of claims 2 to 4, wherein
a first concave part (212) and a second concave part (213) are disposed in the first sliding slot (21), the first concave part (212) and the second concave part (213) are respectively disposed on two side walls that are of the first sliding slot (21) and that are opposite to each other in the rotation axial direction of the hinge mechanism, and the first connecting rod (101) is slidably connected to the first concave part (212) and the second concave part (213); and
a third concave part (312) and a fourth concave part (313) are disposed in the second sliding slot (31), the third concave part (312) and the fourth concave part (313) are respectively disposed on two side walls that are of the second sliding slot (31) and that are opposite to each other in the rotation axial direction of the hinge mechanism, and the second connecting rod (201) is slidably connected to the third concave part (312) and the fourth concave part (313).

6. The hinge mechanism according to any one of claims 1 to 5, wherein
a first sliding part (1011) and a second sliding part (1012) are respectively disposed on two sides of the first connecting rod (101) in the rotation axial direction of the hinge mechanism, and the first sliding part (1011) and the second sliding part (1012) are separately slidably connected to the side wall that is of the first sliding slot (21) and that is in the direction perpendicular to the rotation axial direction of the hinge mechanism; and
a third sliding part and a fourth sliding part are respectively disposed on two sides of the second connecting rod (201) in the rotation axial direction of the hinge mechanism, and the third sliding part and the fourth sliding part are separately slidably connected to the side wall that is of the second sliding slot (31) and that is in the direction perpendicular to the rotation axial direction of the hinge mechanism.

7. The hinge mechanism according to claim 6, wherein
a first arc-shaped surface (10111) is provided on an end that is of the first sliding part (1011) and that is away from the main shaft (1), and a second arc-shaped surface (10121) is provided on an end that is of the second sliding part (1012) and that is away from the main shaft (1); and
a third arc-shaped surface is provided on an end that is of the third sliding part and that is away from the main shaft (1), and a fourth arc-shaped surface is provided on an end that is of the fourth sliding part and that is away from the main shaft (1).

8. The hinge mechanism according to claim 7, wherein
a cross-sectional area of the first sliding part (1011) in the rotation axial direction of the hinge mechanism decreases from the end away from the main shaft (1) to an end close to the main shaft (1), and a cross-sectional area of the second sliding part (1012) in the rotation axial direction of the hinge mechanism decreases from the end away from the main shaft (1) to an end close to the main shaft (1); and
a cross-sectional area of the third sliding part in the rotation axial direction of the hinge mechanism decreases from the end away from the main shaft (1) to an end close to the main shaft (1), and a cross-sectional area of the fourth sliding part in the rotation axial direction of the hinge mechanism decreases from the end away from the main shaft (1) to an end close to the main shaft (1).

9. The hinge mechanism according to any one of claims 4 to 8, wherein
a first stop slot (1013) is disposed on the first connecting rod (101) in a sliding direction of the first connecting rod (101), a first stop protrusion (1022) is disposed on a surface that is of the first stop block (102) and that faces the first connecting rod (101), the first stop protrusion (1022) extends into the first stop slot (1013), and when the electronic device is unfolded to the flattened state, that the first connecting rod (101) presses against the first stop block (102) comprises: an end that is of the first stop slot (1013) and that is away from the main shaft (1) presses against the first stop protrusion (1022); and
a second stop slot is disposed on the second connecting rod (201) in a sliding direction of the second connecting rod (201), a second stop protrusion is disposed on a surface that is of the second stop block (202) and that faces the second connecting rod (201), the second stop protrusion extends into the second stop slot, and when the electronic device is unfolded to the flattened state, that the second connecting rod (201) presses against the second stop block (202) comprises: an end that is of the second stop slot and that is away from the main shaft (1) presses against the second stop protrusion.

10. The hinge mechanism according to any one of claims 1 to 9, wherein
a first mounting slot (22) and a second mounting slot (23) are disposed on the first housing support (2), the first mounting slot (22) and the second mounting slot (23) are respectively located on the two sides of the first connecting rod (101) in the rotation axial direction of the hinge mechanism, and two ends of the first stop block (102) in the rotation axial direction of the hinge mechanism are respectively fastened to the first mounting slot (22) and the second mounting slot (23); and
a third mounting slot and a fourth mounting slot are disposed on the second housing support (3), the third mounting slot and the fourth mounting slot are respectively located on the two sides of the second connecting rod (201) in the rotation axial direction of the hinge mechanism, and two ends of the second stop block (202) in the rotation axial direction of the hinge mechanism are respectively fastened to the third mounting slot and the fourth mounting slot.

11. The hinge mechanism according to any one of claims 1 to 10, wherein a first gear part (1015) is disposed at an end that is of the first connecting rod (101) and that is rotatably connected to the main shaft (1), a second gear part (2015) is disposed at an end that is of the second connecting rod (201) and that is rotatably connected to the main shaft (1), and the first gear part (1015) is in transmission connection to the second gear part (2015), so that the first connecting rod (101) and the second connecting rod (201) synchronously rotate away from or close to each other relative to the main shaft (1).

12. The hinge mechanism according to claim 11, wherein a synchronization gear group is disposed on the main shaft (1), the synchronization gear group is located between the first connecting rod (101) and the second connecting rod (201), and the first gear part (1015) is in transmission connection to the second gear part (2015) through the synchronization gear group; and
the synchronization gear group comprises an even number of transmission gears that are sequentially in transmission connection to each other.

13. An electronic device, comprising a first housing, a second housing, a flexible display, and the hinge mechanism according to any one of claims 1 to 12, wherein
the first housing and the second housing are respectively disposed on two opposite sides of the hinge mechanism, the first housing is fastened to the first housing support (2), and the second housing is fastened to the second housing support (3); and
the flexible display continuously covers the first housing, the second housing, and the hinge mechanism, and the flexible display is fastened to the first housing and the second housing.

## Patentansprüche

1. Scharniermechanismus, der in einer faltbaren elektronischen Vorrichtung verwendet wird, wobei der Scharniermechanismus gegenüber einem faltbaren Teil einer flexiblen Anzeige der elektronischen Vorrichtung angeordnet ist, die elektronische Vorrichtung unter Verwendung des Scharniermechanismus aufgeklappt oder zugeklappt wird, der Scharniermechanismus eine Hauptwelle (1), eine erste Gehäusestütze (2), eine zweite Gehäusestütze (3) und einen Flachheits-Anschlagmechanismus umfasst, die erste Gehäusestütze (2) und die zweite Gehäusestütze (3) jeweils auf zwei gegenüberliegenden Seiten der Hauptwelle (1) angeordnet sind und der Flachheits-Anschlagmechanismus eine erste Anschlagstruktur (10) und eine zweite Anschlagstruktur (20) umfasst, wobei
die erste Anschlagstruktur (10) eine erste Verbindungsstange (101) und einen ersten Anschlagblock (102) umfasst, wobei die erste Verbindungsstange (101) drehbar mit der Hauptwelle (1) verbunden ist, die erste Verbindungsstange (101) gleitend mit der ersten Gehäusestütze (2) verbunden ist, der erste Anschlagblock (102) an der ersten Gehäusestütze (2) befestigt ist und der erste Anschlagblock (102) gegenüber der ersten Verbindungsstange (101) angeordnet ist;
die zweite Anschlagstruktur (20) eine zweite Verbindungsstange (201) und einen zweiten Anschlagblock (202) umfasst, wobei die zweite Verbindungsstange (201) drehbar mit der Hauptwelle (1) verbunden ist, die zweite Verbindungsstange (201) gleitend mit der zweiten Gehäusestütze (3) verbunden ist, der zweite Anschlagblock (202) an der zweiten Gehäusestütze (3) befestigt ist und der zweite Anschlagblock (202) gegenüber der zweiten Verbindungsstange (201) angeordnet ist; und
die erste Verbindungsstange (101) in Übertragungsverbindung mit der zweiten Verbindungsstange (201) steht; wenn die elektronische Vorrichtung aufgeklappt oder zugeklappt wird, drehen sich die erste Gehäusestütze (2) und die zweite Gehäusestütze (3) synchron voneinander weg oder aufeinander zu relativ zu der Hauptwelle (1), die erste Verbindungsstange (101) und die zweite Verbindungsstange (201) drehen sich synchron voneinander weg oder aufeinander zu relativ zu der Hauptwelle (1), die erste Verbindungsstange (101) gleitet relativ zu der ersten Gehäusestütze (2) und die zweite Verbindungsstange (201) gleitet relativ zu der zweiten Gehäusestütze (3); bei einem Vorgang, bei dem die elektronische Vorrichtung in einen flachen Zustand aufgeklappt wird, gleitet die erste Verbindungsstange (101) in eine Richtung weg von der ersten Gehäusestütze (2) und die zweite Verbindungsstange (201) gleitet in eine Richtung weg von der zweiten Gehäusestütze (3); und, wenn die elektronische Vorrichtung in den flachen Zustand aufgeklappt wird, drückt die erste Verbindungsstange (101) gegen den ersten Anschlagblock (102) und die zweite Verbindungsstange (201) drückt gegen den zweiten Anschlagblock (202).

2. Scharniermechanismus nach Anspruch 1, wobei
ein erster Gleitschlitz (21) an der ersten Gehäusestütze (2) angeordnet ist, der erste Gleitschlitz (21) sich in eine Richtung weg von der Hauptwelle (1) erstreckt, die erste Verbindungsstange (101) gleitend in dem ersten Gleitschlitz (21) angeordnet ist und, wenn die elektronische Vorrichtung aufgeklappt oder zugeklappt wird, die erste Verbindungsstange (101) relativ zu der ersten Gehäusestütze (2) in die Richtung weg von der ersten Gehäusestütze (2) oder in eine Richtung auf die erste Gehäusestütze (2) zu gleitet; und
ein zweiter Gleitschlitz (31) an der zweiten Gehäusestütze (3) angeordnet ist, der zweite Gleitschlitz (31) sich in eine Richtung weg von der Hauptwelle (1) erstreckt, die zweite Verbindungsstange (201) gleitend in dem zweiten Gleitschlitz (31) angeordnet ist und, wenn die elektronische Vorrichtung aufgeklappt oder zugeklappt wird, die zweite Verbindungsstange (201) relativ zu der zweiten Gehäusestütze (3) in die Richtung weg von der zweiten Gehäusestütze (3) oder in eine Richtung auf die zweite Gehäusestütze (3) zu gleitet.

3. Scharniermechanismus nach Anspruch 2, wobei
ein erster Umgehungsschlitz (211) in dem ersten Gleitschlitz (21) angeordnet ist und der erste Umgehungsschlitz (211) an einer Seitenwand angeordnet ist, die zu dem ersten Gleitschlitz (21) gehört und die in einer Richtung senkrecht zu einer Drehachsenrichtung des Scharniermechanismus verläuft; und
ein zweiter Umgehungsschlitz in dem zweiten Gleitschlitz (31) angeordnet ist und der zweite Umgehungsschlitz an einer Seitenwand angeordnet ist, die zu dem zweiten Gleitschlitz (31) gehört und die in der Richtung senkrecht zu der Drehachsenrichtung des Scharniermechanismus liegt.

4. Scharniermechanismus nach Anspruch 2 oder 3, wobei eine erste Öffnung in dem ersten Gleitschlitz (21) in der Richtung senkrecht zu der Drehachsenrichtung des Scharniermechanismus angeordnet ist, der erste Anschlagblock (102) die erste Öffnung abdeckt und ein Teil der ersten Verbindungsstange (101) sich zwischen dem ersten Anschlagblock (102) und der ersten Gehäusestütze (2) befindet; und
eine zweite Öffnung in dem zweiten Gleitschlitz (31) in der Richtung senkrecht zu der Drehachsenrichtung des Scharniermechanismus angeordnet ist, der zweite Anschlagblock (202) die zweite Öffnung abdeckt und ein Teil der zweiten Verbindungsstange (201) sich zwischen dem zweiten Anschlagblock (202) und der zweiten Gehäusestütze (3) befindet.

5. Scharniermechanismus nach einem der Ansprüche 2 bis 4, wobei ein erster konkaver Teil (212) und ein zweiter konkaver Teil (213) in dem ersten Gleitschlitz (21) angeordnet sind, der erste konkave Teil (212) und der zweite konkave Teil (213) jeweils an zwei Seitenwänden angeordnet sind, die zu dem ersten Gleitschlitz (21) gehören und die einander in der Drehachsenrichtung des Scharniermechanismus gegenüberliegen, und die erste Verbindungsstange (101) gleitend mit dem ersten konkaven Teil (212) und dem zweiten konkaven Teil (213) verbunden ist; und
ein dritter konkaver Teil (312) und ein vierter konkaver Teil (313) in dem zweiten Gleitschlitz (31) angeordnet sind, der dritte konkave Teil (312) und der vierte konkave Teil (313) jeweils an zwei Seitenwänden angeordnet sind, die zu dem zweiten Gleitschlitz (31) gehören und die einander in der Drehachsenrichtung des Scharniermechanismus gegenüberliegen, und die zweite Verbindungsstange (201) gleitend mit dem dritten konkaven Teil (312) und dem vierten konkaven Teil (313) verbunden ist.

6. Scharniermechanismus nach einem der Ansprüche 1 bis 5, wobei ein erster Gleitteil (1011) und ein zweiter Gleitteil (1012) jeweils auf zwei Seiten der ersten Verbindungsstange (101) in der Drehachsenrichtung des Scharniermechanismus angeordnet sind und der erste Gleitteil (1011) und der zweite Gleitteil (1012) separat gleitend mit der Seitenwand verbunden sind, die zu dem ersten Gleitschlitz (21) gehört und die in der Richtung senkrecht zu der Drehachsenrichtung des Scharniermechanismus liegt; und
ein dritter Gleitteil und ein vierter Gleitteil jeweils auf zwei Seiten der zweiten Verbindungsstange (201) in der Drehachsenrichtung des Scharniermechanismus angeordnet sind und der dritte Gleitteil und der vierte Gleitteil separat gleitend mit der Seitenwand verbunden sind, die zu dem zweiten Gleitschlitz (31) gehört und die in der Richtung senkrecht zu der Drehachsenrichtung des Scharniermechanismus liegt.

7. Scharniermechanismus nach Anspruch 6, wobei
eine erste bogenförmige Fläche (10111) an einem Ende bereitgestellt ist, das zu dem ersten Gleitteil (1011) gehört und das von der Hauptwelle (1) abgewandt ist, und eine zweite bogenförmige Fläche (10121) an einem Ende bereitgestellt ist, das zu dem zweiten Gleitteil (1012) gehört und das von der Hauptwelle (1) abgewandt ist; und
eine dritte bogenförmige Fläche an einem Ende bereitgestellt ist, das zu dem dritten Gleitteil gehört und das von der Hauptwelle (1) abgewandt ist, und eine vierte bogenförmige Fläche an einem Ende bereitgestellt ist, das zu dem vierten Gleitteil gehört und das von der Hauptwelle (1) abgewandt ist.

8. Scharniermechanismus nach Anspruch 7, wobei
eine Querschnittsfläche des ersten Gleitteils (1011) in der Drehachsenrichtung des Scharniermechanismus von dem Ende, das von der Hauptwelle (1) entfernt ist, zu einem Ende, das nahe der Hauptwelle (1) ist, abnimmt und eine Querschnittsfläche des zweiten Gleitteils (1012) in der Drehachsenrichtung des Scharniermechanismus von dem Ende, das von der Hauptwelle (1) entfernt ist, zu einem Ende, das nahe der Hauptwelle (1) ist, abnimmt; und
eine Querschnittsfläche des dritten Gleitteils in der Drehachsenrichtung des Scharniermechanismus von dem Ende, das von der Hauptwelle (1) entfernt ist, zu einem Ende, das nahe der Hauptwelle (1) ist, abnimmt und eine Querschnittsfläche des vierten Gleitteils in der Drehachsenrichtung des Scharniermechanismus von dem Ende, das von der Hauptwelle (1) entfernt ist, zu einem Ende, das nahe der Hauptwelle (1) ist, abnimmt.

9. Scharniermechanismus nach einem der Ansprüche 4 bis 8, wobei ein erster Anschlagschlitz (1013) auf der ersten Verbindungsstange (101) in einer Gleitrichtung der ersten Verbindungsstange (101) angeordnet ist, ein erster Anschlagvorsprung (1022) an einer Fläche angeordnet ist, die zu dem ersten Anschlagblock (102) gehört und die der ersten Verbindungsstange (101) zugewandt ist, der erste Anschlagvorsprung (1022) sich in den ersten Anschlagschlitz (1013) erstreckt und wobei, wenn die elektronische Vorrichtung in den flachen Zustand aufgeklappt ist, die Tatsache, dass die erste Verbindungsstange (101) gegen den ersten Anschlagblock (102) drückt, Folgendes umfasst: ein Ende, das zu dem ersten Anschlagschlitz (1013) gehört und das von der Hauptwelle (1) entfernt ist, drückt gegen den ersten Anschlagvorsprung (1022); und
ein zweiter Anschlagschlitz auf der zweiten Verbindungsstange (201) in einer Gleitrichtung der zweiten Verbindungsstange (201) angeordnet ist, ein zweiter Anschlagvorsprung auf einer Fläche angeordnet ist, die zu dem zweiten Anschlagblock (202) gehört und die der zweiten Verbindungsstange (201) zugewandt ist, der zweite Anschlagvorsprung sich in den zweiten Anschlagschlitz erstreckt und wobei, wenn die elektronische Vorrichtung in den flachen Zustand aufgeklappt ist, die Tatsache, dass die zweite Verbindungsstange (201) gegen den zweiten Anschlagblock (202) drückt, Folgendes umfasst: ein Ende, das zu dem zweiten Anschlagschlitz gehört und das von der Hauptwelle (1) entfernt ist, drückt gegen den zweiten Anschlagvorsprung.

10. Scharniermechanismus nach einem der Ansprüche 1 bis 9, wobei ein erster Montageschlitz (22) und ein zweiter Montageschlitz (23) auf der ersten Gehäusestütze (2) angeordnet sind, der erste Montageschlitz (22) und der zweite Montageschlitz (23) sich jeweils auf den zwei Seiten der ersten Verbindungsstange (101) in der Drehachsenrichtung des Scharniermechanismus befinden und zwei Enden des ersten Anschlagblocks (102) in der Drehachsenrichtung des Scharniermechanismus jeweils an dem ersten Montageschlitz (22) und dem zweiten Montageschlitz (23) befestigt sind; und
ein dritter Montageschlitz und ein vierter Montageschlitz an der zweiten Gehäusestütze (3) angeordnet sind, der dritte Montageschlitz und der vierte Montageschlitz sich jeweils auf den zwei Seiten der zweiten Verbindungsstange (201) in der Drehachsenrichtung des Scharniermechanismus befinden und zwei Enden des zweiten Anschlagblocks (202) in der Drehachsenrichtung des Scharniermechanismus jeweils an dem dritten Montageschlitz und dem vierten Montageschlitz befestigt sind.

11. Scharniermechanismus nach einem der Ansprüche 1 bis 10, wobei ein erster Zahnradteil (1015) an einem Ende angeordnet ist, das zu der ersten Verbindungsstange (101) gehört und das drehbar mit der Hauptwelle (1) verbunden ist, ein zweiter Zahnradteil (2015) an einem Ende angeordnet ist, das zu der zweiten Verbindungsstange (201) gehört und das drehbar mit der Hauptwelle (1) verbunden ist, und der erste Zahnradteil (1015) in Übertragungsverbindung mit dem zweiten Zahnradteil (2015) steht, sodass die erste Verbindungsstange (101) und die zweite Verbindungsstange (201) sich relativ zu der Hauptwelle (1) synchron voneinander weg oder aufeinander zu drehen.

12. Scharniermechanismus nach Anspruch 11, wobei eine Synchronisationszahnradgruppe auf der Hauptwelle (1) angeordnet ist, die Synchronisationszahnradgruppe sich zwischen der ersten Verbindungsstange (101) und der zweiten Verbindungsstange (201) befindet und der erste Zahnradteil (1015) über die Synchronisationszahnradgruppe in Getriebeverbindung mit dem zweiten Zahnradteil (2015) steht; und
die Synchronisationszahnradgruppe eine gerade Anzahl von Getriebezahnrädern umfasst, die sequentiell miteinander in Getriebeverbindung stehen.

13. Elektronische Vorrichtung, umfassend ein erstes Gehäuse, ein zweites Gehäuse, eine flexible Anzeige und den Scharniermechanismus nach einem der Ansprüche 1 bis 12, wobei das erste Gehäuse und das zweite Gehäuse jeweils auf zwei gegenüberliegenden Seiten des Scharniermechanismus angeordnet sind, das erste Gehäuse an der ersten Gehäusestütze (2) befestigt ist und das zweite Gehäuse an der zweiten Gehäusestütze (3) befestigt ist; und
die flexible Anzeige durchgehend das erste Gehäuse, das zweite Gehäuse und den Scharniermechanismus abdeckt und die flexible Anzeige an dem ersten Gehäuse und dem zweiten Gehäuse befestigt ist.

## Revendications

1. Mécanisme de charnière, utilisé dans un dispositif électronique pliable, dans lequel le mécanisme de charnière est disposé en face d'une partie pliable d'un écran flexible du dispositif électronique, le dispositif électronique est déplié ou plié à l'aide du mécanisme de charnière, le mécanisme de charnière comprend un arbre principal (1), un premier support de boîtier (2), un second support de boîtier (3), et un mécanisme de butée de planéité, le premier support de boîtier (2) et le second support de boîtier (3) sont respectivement disposés sur deux côtés opposés de l'arbre principal (1), et le mécanisme de butée de planéité comprend une première structure de butée (10) et une seconde structure de butée (20), dans lequel
la première structure de butée (10) comprend une première tige de liaison (101) et un premier bloc de butée (102), dans lequel la première tige de liaison (101) est reliée de manière rotative à l'arbre principal (1), la première tige de liaison (101) est reliée de manière coulissante au premier support de boîtier (2), le premier bloc de butée (102) est fixé au premier support de boîtier (2), et le premier bloc de butée (102) est disposé à l'opposé de la première tige de liaison (101) ;
la seconde structure de butée (20) comprend une seconde tige de liaison (201) et un second bloc de butée (202), dans lequel la seconde tige de liaison (201) est reliée de manière rotative à l'arbre principal (1), la seconde tige de liaison (201) est reliée de manière coulissante au second support de boîtier (3), le second bloc de butée (202) est fixé au second support de boîtier (3), et le second bloc de butée (202) est disposé à l'opposé de la seconde tige de liaison (201) ; et
la première tige de liaison (101) est en liaison de transmission avec la seconde tige de liaison (201) ; lorsque le dispositif électronique est déplié ou plié, le premier support de boîtier (2) et le second support de boîtier (3) tournent de manière synchrone en s'éloignant ou en se rapprochant l'un de l'autre par rapport à l'arbre principal (1), la première tige de liaison (101) et la seconde tige de liaison (201) tournent de manière synchrone en s'éloignant ou en se rapprochant l'une de l'autre par rapport à l'arbre principal (1), la première tige de liaison (101) coulisse par rapport au premier support de boîtier (2), et la seconde tige de liaison (201) coulisse par rapport au second support de boîtier (3) ; dans un processus dans lequel le dispositif électronique est déplié à un état aplati, la première tige de liaison (101) coulisse dans une direction en s'éloignant du premier support de boîtier (2), et la seconde tige de liaison (201) coulisse dans une direction en s'éloignant du second support de boîtier (3) ; et lorsque le dispositif électronique est déplié à l'état aplati, la première tige de liaison (101) appuie contre le premier bloc de butée (102), et la seconde tige de liaison (201) appuie contre le second bloc de butée (202).

2. Mécanisme de charnière selon la revendication 1, dans lequel une première fente coulissante (21) est disposée sur le premier support de boîtier (2), la première fente coulissante (21) se prolonge dans une direction éloignée de l'arbre principal (1), la première tige de liaison (101) est disposée de manière coulissante dans la première fente coulissante (21), et lorsque le dispositif électronique est déplié ou plié, la première tige de liaison (101) coulisse par rapport au premier support de boîtier (2) dans la direction éloignée du premier support de boîtier (2) ou une direction proche du premier support de boîtier (2) ; et une seconde fente coulissante (31) est disposée sur le second support de boîtier (3), la seconde fente coulissante (31) se prolonge dans une direction s'éloignant de l'arbre principal (1), la seconde tige de liaison (201) est disposée de manière coulissante dans la seconde fente coulissante (31), et lorsque le dispositif électronique est déplié ou plié, la seconde tige de liaison (201) coulisse par rapport au second support de boîtier (3) dans la direction s'éloignant du second support de boîtier (3) ou une direction proche du second support de boîtier (3).

3. Mécanisme de charnière selon la revendication 2, dans lequel une première fente d'évitement (211) est disposée dans la première fente coulissante (21), et la première fente d'évitement (211) est disposée sur une paroi latérale qui est celle de la première fente coulissante (21) et qui est dans une direction perpendiculaire à une direction axiale de rotation du mécanisme de charnière ; et
une seconde fente d'évitement est disposée dans la seconde fente coulissante (31), et la seconde fente d'évitement est disposée sur une paroi latérale qui est celle de la seconde fente coulissante (31) et qui est dans la direction perpendiculaire à la direction axiale de rotation du mécanisme de charnière.

4. Mécanisme de charnière selon la revendication 2 ou 3, dans lequel
une première ouverture est disposée dans la première fente coulissante (21) dans la direction perpendiculaire à la direction axiale de rotation du mécanisme de charnière, le premier bloc de butée (102) recouvre la première ouverture, et une partie de la première tige de liaison (101) est située entre le premier bloc de butée (102) et le premier support de boîtier (2) ; et une seconde ouverture est disposée dans la seconde fente coulissante (31) dans la direction perpendiculaire à la direction axiale de rotation du mécanisme de charnière, le second bloc de butée (202) recouvre la seconde ouverture, et une partie de la seconde tige de liaison (201) est située entre le second bloc de butée (202) et le second support de boîtier (3).

5. Mécanisme de charnière selon l'une quelconque des revendications 2 à 4, dans lequel
une première partie concave (212) et une deuxième partie concave (213) sont disposées dans la première fente coulissante (21), la première partie concave (212) et la deuxième partie concave (213) sont respectivement disposées sur deux parois latérales qui sont celles de la première fente coulissante (21) et qui sont opposées l'une à l'autre dans la direction axiale de rotation du mécanisme de charnière, et la première tige de liaison (101) est reliée de manière coulissante à la première partie concave (212) et à la deuxième partie concave (213) ; et
une troisième partie concave (312) et une quatrième partie concave (313) sont disposées dans la seconde fente coulissante (31), la troisième partie concave (312) et la quatrième partie concave (313) sont respectivement disposées sur deux parois latérales qui sont celles de la seconde fente coulissante (31) et qui sont opposées l'une à l'autre dans la direction axiale de rotation du mécanisme de charnière, et la seconde tige de liaison (201) est reliée de manière coulissante à la troisième partie concave (312) et à la quatrième partie concave (313).

6. Mécanisme de charnière selon l'une quelconque des revendications 1 à 5, dans lequel
une première partie coulissante (1011) et une deuxième partie coulissante (1012) sont respectivement disposées sur deux côtés de la première tige de liaison (101) dans la direction axiale de rotation du mécanisme de charnière, et la première partie coulissante (1011) et la deuxième partie coulissante (1012) sont reliées de manière coulissante séparément à la paroi latérale qui est celle de la première fente coulissante (21) et qui est dans la direction perpendiculaire à la direction axiale de rotation du mécanisme de charnière ; et
une troisième partie coulissante et une quatrième partie coulissante sont respectivement disposées sur deux côtés de la seconde tige de liaison (201) dans la direction axiale de rotation du mécanisme de charnière, et la troisième partie coulissante et la quatrième partie coulissante sont reliées de manière coulissante séparément à la paroi latérale qui est celle de la seconde fente coulissante (31) et qui est dans la direction perpendiculaire à la direction axiale de rotation du mécanisme de charnière.

7. Mécanisme de charnière selon la revendication 6, dans lequel une première surface en forme d'arc (10111) est prévue sur une extrémité qui est celle de la première partie coulissante (1011) et qui est éloignée de l'arbre principal (1), et une deuxième surface en forme d'arc (10121) est prévue sur une extrémité qui est celle de la deuxième partie coulissante (1012) et qui est éloignée de l'arbre principal (1) ; et
une troisième surface en forme d'arc est prévue sur une extrémité qui est celle de la troisième partie coulissante et qui est éloignée de l'arbre principal (1), et une quatrième surface en forme d'arc est prévue sur une extrémité qui est celle de la quatrième partie coulissante et qui est éloignée de l'arbre principal (1).

8. Mécanisme de charnière selon la revendication 7, dans lequel une section transversale de la première partie coulissante (1011) dans la direction axiale de rotation du mécanisme de charnière diminue de l'extrémité éloignée de l'arbre principal (1) à une extrémité proche de l'arbre principal (1), et une section transversale de la deuxième partie coulissante (1012) dans la direction axiale de rotation du mécanisme de charnière diminue de l'extrémité éloignée de l'arbre principal (1) à une extrémité proche de l'arbre principal (1) ; et
une section transversale de la troisième partie coulissante dans la direction axiale de rotation du mécanisme de charnière diminue de l'extrémité éloignée de l'arbre principal (1) à une extrémité proche de l'arbre principal (1), et une section transversale de la quatrième partie coulissante dans la direction axiale de rotation du mécanisme de charnière diminue de l'extrémité éloignée de l'arbre principal (1) à une extrémité proche de l'arbre principal (1).

9. Mécanisme de charnière selon l'une quelconque des revendications 4 à 8, dans lequel
une première fente de butée (1013) est disposée sur la première tige de liaison (101) dans une direction de coulissement de la première tige de liaison (101), une première saillie de butée (1022) est disposée sur une surface qui est celle du premier bloc de butée (102) et qui fait face à la première tige de liaison (101), la première saillie de butée (1022) se prolonge dans la première fente de butée (1013), et lorsque le dispositif électronique est déplié à l'état aplati, le fait que la première tige de liaison (101) appuie contre le premier bloc de butée (102) comprend : une extrémité qui est celle de la première fente de butée (1013) qui est éloignée de l'arbre principal (1) appuie contre la première saillie de butée (1022) ; et
une seconde fente de butée est disposée sur la seconde tige de liaison (201) dans une direction de coulissement de la seconde tige de liaison (201), une seconde saillie de butée est disposée sur une surface qui est celle du second bloc de butée (202) et qui fait face à la seconde tige de liaison (201), la seconde saillie de butée se prolonge dans la seconde fente de butée, et lorsque le dispositif électronique est déplié à l'état aplati, le fait que la seconde tige de liaison (201) appuie contre le second bloc de butée (202) comprend : une extrémité qui est celle de la seconde fente de butée qui est éloignée de l'arbre principal (1) appuie contre la seconde saillie de butée.

10. Mécanisme de charnière selon l'une quelconque des revendications 1 à 9, dans lequel
une première fente de montage (22) et une deuxième fente de montage (23) sont disposées sur le premier support de boîtier (2), la première fente de montage (22) et la deuxième fente de montage (23) sont respectivement situées sur les deux côtés de la première tige de liaison (101) dans la direction axiale de rotation du mécanisme de charnière, et deux extrémités du premier bloc de butée (102) dans la direction axiale de rotation du mécanisme de charnière sont respectivement fixées à la première fente de montage (22) et à la deuxième fente de montage (23) ; et
une troisième fente de montage et une quatrième fente de montage sont disposées sur le second support de boîtier (3), la troisième fente de montage et la quatrième fente de montage sont respectivement situées sur les deux côtés de la seconde tige de liaison (201) dans la direction axiale de rotation du mécanisme de charnière, et deux extrémités du second bloc de butée (202) dans la direction axiale de rotation du mécanisme de charnière sont respectivement fixées à la troisième fente de montage et à la quatrième fente de montage.

11. Mécanisme de charnière selon l'une quelconque des revendications 1 à 10, dans lequel une première partie d'engrenage (1015) est disposée à une extrémité qui est celle de la première tige de liaison (101) et qui est reliée de manière rotative à l'arbre principal (1), une seconde partie d'engrenage (2015) est disposée à une extrémité qui est celle de la seconde tige de liaison (201) et qui est reliée de manière rotative à l'arbre principal (1), et la première partie d'engrenage (1015) est en liaison de transmission avec la seconde partie d'engrenage (2015), de sorte que la première tige de liaison (101) et la seconde tige de liaison (201) tournent de manière synchrone en s'éloignant ou en se rapprochant l'une de l'autre par rapport à l'arbre principal (1).

12. Mécanisme de charnière selon la revendication 11, dans lequel un groupe d'engrenage de synchronisation est disposé sur l'arbre principal (1), le groupe d'engrenage de synchronisation est situé entre la première tige de liaison (101) et la seconde tige de liaison (201), et la première partie d'engrenage (1015) est en liaison de transmission avec la seconde partie d'engrenage (2015) à travers le groupe d'engrenage de synchronisation ; et
le groupe d'engrenage de synchronisation comprend un nombre pair d'engrenages de transmission qui sont séquentiellement en liaison de transmission les uns avec les autres.

13. Dispositif électronique, comprenant un premier boîtier, un second boîtier, un écran flexible, et le mécanisme de charnière selon l'une quelconque des revendications 1 à 12, dans lequel le premier boîtier et le second boîtier sont respectivement disposés sur deux côtés opposés du mécanisme de charnière, le premier boîtier est fixé au premier support de boîtier (2), et le second boîtier est fixé au second support de boîtier (3) ; et
l'écran flexible recouvre en continu le premier boîtier, le second boîtier, et le mécanisme de charnière, et l'écran flexible est fixé au premier boîtier et au second boîtier.
